# EUROPÄISCHE PATENTSCHRIFT

(11) **EP 1 380 196 B1**
(45) Veröffentlichungstag und Bekanntmachung des Hinweises auf die Patenterteilung: **14.06.2006**
(21) Anmeldenummer: 02732610.7
(22) Anmeldetag: 12.04.2002
(51) Int. Cl.: H05K 7/18, H05K 5/00, H05K 7/00

(54) **EINSCHUBRAHMEN**
PLUG-IN RACK
CHASSIS D'INSERTION

(30) Priorität: 12.04.2001 EP 01109194
(43) Veröffentlichungstag der Anmeldung: 14.01.2004
(73) Patentinhaber: Lufthansa Technik AG, 22335 Hamburg (DE)
(72) Erfinder: MUIRHEAD, Andrew, 22846 Norderstedt (DE); STARKE, Henry, 25474 Ellerbek (DE)
(74) Vertreter: Glawe, Delfs, Moll
(86) Internationale Anmeldenummer: PCT/EP2002/004093
(87) Internationale Veröffentlichungsnummer: WO 2002/085088

(56) Entgegenhaltungen:
- EP-A- 0 049 517
- WO-A-98/47334
- US-A- 2 871 457
- US-A- 4 089 040
- US-A- 4 123 129
- US-A- 5 305 187

## Beschreibung

Die Erfindung betrifft einen Einschubrahmen für Flugzeuge, der eine oder mehrere übereinanderliegende Reihen mit jeweils einem oder mehreren nebeneinanderliegenden Einschubfächern zur Aufnahme von Elektronikeinheiten aufweist, wobei ein Einschubfach zum unabhängigen Einschieben bzw. Ausziehen einer Elektronikeinheit eingerichtet ist. Einem Einschubfach ist jeweils ein erster elektrischer Steckverbinder so zugeordnet, daß ein Zusammenwirken des ersten Steckverbinders mit einem entsprechendem zweiten Steckverbinder einer Elektronikeinheit allein infolge des Einschiebens der Elektronikeinheit in das Einschubfach bewirkbar ist.

Ein derartiger Einschubrahmen ist bspw. im sog. E/E-Bereich des Flugzeugs unterhalb des Cockpits vorgesehen und dient zur Aufnahme von Elektronikeinheiten (sog. LRUs, line replaceable units). Für die Elektronikeinheiten und die Einschubrahmen existieren eine Reihe von Spezifikationen (bspw. ARINC, Lufthansa Technik XXL). Es ist bekannt, den ersten elektrischen Steckverbinder an einem L-förmigen Bauteil, dem sogenannten Tray, vorzusehen, wobei das Tray aus einem Boden- und einem Rückenteil gebildet ist. Der erste Steckverbinder ist Teil eines in der Rückwand eingelassenen Adapters. Das Tray ist im Gebrauch fest mit dem Boden eines Einschubfachs des Einschubrahmens verbunden. Der Adapter ist rückseitig mit den entsprechenden Anschlußleitungen verbunden. Der Innenraum des Trays, d. h. das durch die L-Form definierte quaderförmige Volumen, ist zur Aufnahme einer Elektronikeinheit eingerichtet. Diese weist an ihrer Rückseite einen entsprechenden zweiten Steckverbinder auf. Der erste Steckverbinder ist so angeordnet, daß die elektrische Verbindung allein infolge des Einschiebens der Elektronikeinheit in das Einschubfach bewirkt wird, ohne daß ein zusätzlicher Handgriff erforderlich ist. Auf diese Weise wird ein schnellstmögliches Auswechseln der Elektronikeinheiten ermöglicht. Die Elektronikeinheiten werden mit Arretiereinrichtungen (sogenannte Hold-downs) im Einschubrahmen gehalten. Die Ausführung des Trays als separates Bauteil ermöglicht es, dieses mit dem Adapter vom Einschubrahmen zu trennen und das Tray gegen ein anderes auszutauschen. Dies kann bspw. erforderlich sein, wenn der Adapter defekt ist.

Einschubrahmen mit einer festen Gesamtgröße sind beispielsweise aus US-2,871,457, US- 4,089,040 und US-5,441,337 bekannt. In diese bekannten Einschubrahmen können mehrere Elektronikeinheiten eingesetzt werden, die unterschiedliche Höhen- oder Breitenabmessungen aufweisen können. Zur Anpassung an die unterschiedlichen Abmessungen kann die Innenaufteilung des Einschubrahmens geändert werden. Eine Anpassung der Außenabmessungen ist nicht vorgesehen.

Ferner sind Einschubrahmen bekannt, in die Einschübe einer festen Breite eingesetzt werden können (z. B. US-5,441,337). Üblich ist hierbei eine Breite von 19 Zoll (sogenanntes 19 Zoll-Rack). Die Einschübe für solche Einschubrahmen weisen dementsprechend ebenfalls eine feste Breite von üblicherweise 19 Zoll auf. Einschübe für ein 19 Zoll-Rack sind z. B. aus US-4,014,598, EP-A-0 560 067 und DE-A-3409022 bekannt. In den Einschüben sind zur Aufnahme von Elektronikplatinen einfache Schienen angeordnet. Diese sogenannten 19 Zoll-Systeme haben den Nachteil, daß sie Flexibilität bezüglich der Aufteilung nur hinsichtlich des Innenraums bieten. Die äußeren Abmessungen sind durch das Rack selbst festgelegt und können nicht nachträglich verändert oder angepaßt werden. Auch wenn das 19 Zoll-Rack aus einzelnen Elementen aufgebaut ist, wie in US-5,441,337 beschrieben, ist nicht vorgesehen, im montierten Zustand einzelne Elemente auszutauschen. Eine Anpassung an unterschiedliche Einbauverhältnisse ist damit nicht oder nur schwer möglich.

Gehäusesysteme zur Aufnahme von Einschüben, bei denen beim Einsetzen der Einschübe automatisch elektrische Steckverbindung hergestellt wird, sind für sich genommen bereits bekannt (US-4,977,532 und US-4,967,311). Sie weisen jedoch ebenfalls feste Abmessungen auf. Eine Anpassung an unterschiedliche Einbauverhältnisse ist damit nicht möglich.

Die bekannten Einschubrahmen müssen daher von vornherein entsprechend den jeweiligen Einbauverhältnissen des Flugzeugtyps konstruiert sein. Damit ist für jeden unterschiedlichen Flugzeugtyp auch ein spezifischer Einschubrahmen erforderlich. Das ist aufwendig hinsichtlich Herstellung und Lagerung.

Aufgabe der Erfindung ist es, ein universelleres System zu schaffen, bei dem der Aufwand zur Herstellung von Einschubrahmen der eingangs genannten Art reduziert und/oder die Zahl der vorzuhaltenden Teile reduziert sind.

Die Erfindung schlägt zu diesem Zweck einen enschus modularen Luftfahrzeugeinschubrahmen gemäß Anspruch 1 vor.

Zunächst werden einige der verwendeten Begriffe erläutert.

Die Begriffe Elektronikeinheit und (Elektronik-)Einschub werden synonym verwendet. "Übereinander liegend" bzw. "nebeneinander liegend" ist nicht so zu verstehen, daß ein Einschubrahmen mindestens zwei (horizontale) Reihen von Einschubfächern umfassen muß oder jede Reihe mindestens zwei Einschubfächer aufweisen muß. Die Erfindung umfaßt bspw. auch einen Einschubrahmen mit lediglich einer Reihe von Einschubfächern (sog. shelf). Im allgemeinen wird es sich um einen Einschubrahmen mit mindestens zwei, vorzugsweise mindestens drei miteinander zu verbindenden Reihen von Einschubfächern handeln. Die Begriffe "übereinander liegend" und "nebeneinander liegend" sollen andeuten, daß ein Einschubrahmen im allgemeinen einen matrixartigen Aufbau mit Reihen und Spalten aufweist.

Ein einheitlicher Einschubrahmen ist ein solcher, bei dem sämtliche Rahmenteile in Verbindung mit dem Einschubrahmen stehen und der den bei einem Flugzeug auftretenden Belastungsanforderungen entspricht. Der gesamte Einschubrahmen soll daher auch im vollständig beschickten Zustand bspw. Beschleunigungen von bis zu 10 g problemlos überstehen.

Die Einrichtung eines Einschubfachs zum "unabhängigen Einschieben bzw. Ausziehen" einer Elektronikeinheit bedeutet, daß ein Auswechseln einer Elektronikeinheit ohne Beeinflussung oder Beeinträchtigung des Einschubrahmens und/oder weiterer ggf. eingeschobener Elektronikeinheiten erfolgen kann. Dies bedeutet notwendigerweise, daß eine Elektronikeinheit oder Teile einer solchen nicht Teil des Einschubrahmens sein kann. Nur dadurch ist ein schnelles und unabhängiges Auswechseln beliebiger Elektronikeinheiten gewährleistet.

Die elektrische Versorgung einer in ein Einschubfach eingeschobenen Elektronikeinheit und die Signalübertragung von und zu der Elektronikeinheit erfolgt jeweils über einen ersten und einen zweiten zum Zusammenwirken miteinander eingerichtete Steckverbinder. Der zweite Steckverbinder ist jeweils an der Elektronikeinheit angeordnet, während der erste Steckverbinder rückseitig mit den entsprechenden Versorgungs-und/oder Signalleitungen verbunden ist. Das Merkmal, daß das Zusammenwirken einander entsprechender erster und zweiter Steckverbinder allein infolge des Einschiebens der Elektronikeinheit in das Einschubfach bewirkbar ist, bedeutet, daß der elektrische Kontakt beim Einschieben automatisch hergestellt wird, ohne daß es eines zusätzlichen Handgriffs bedarf. Dies kann bspw. dadurch bewirkt werden, daß der zweite Steckverbinder relativ zum Einschubfach räumlich fixiert ist, und zwar mit entgegen der Einschubrichtung orientierter Steckeröffnung. Die räumliche Fixierung setzt den Kräften, die auf den zweiten Steckverbinder infolge des Einschiebens wirken, ausreichend Widerstand entgegen. Vorzugsweise sind die Steckverbinder so gestaltet, daß dieser Widerstand gering ist (low or zero insertion force). Vorzugsweise weisen die Steckverbinder miteinander zusammenwirkende Führungsflächen auf, die das Einschieben erleichtern.

"Im wesentlichen flach" bedeutet, daß die Rahmenteile im Mittel in einer Raumrichtung eine mindestens um den Faktor 3, vorzugsweise mindestens 5, weiter vorzugsweise mindestens 7 geringere Ausdehnung aufweisen als in den beiden übrigen Raumrichtungen. Auf die spezifische Form eines Rahmenteils kommt es dabei nicht an. Für die Seiten- und/oder Rückenteile beträgt der genannte Faktor weiter vorzugsweise mindestens 10, weiter vorzugsweise mindestens 20. Insbesondere die L-förmigen Trays des Standes der Technik sind nicht flach im genannten Sinne. Flache Rahmenteile sind bspw. hinsichtlich Lagerhaltung vorteilhaft.

Das Merkmal, daß die Breite eines Rahmenteils jeweils der Breite eines Einschubfachs entspricht, ist nicht so zu verstehen, daß die Breite des Rahmenteils exakt gleich der Breite des entsprechenden Einschubfachs sein muß. Das Merkmal bedeutet lediglich, daß sich die Rahmenteile in ihrer Breite nicht über im wesentlichen jeweils zwei oder mehr Einschubfächer erstrecken.

Nach einem bevorzugten Merkmal der Erfindung entspricht die Höhe mindestens eines Teils der Rückenteile jeweils der Höhe eines Einschubfachs und sind die Rückenteile jeweils zur Verbindung mit dem oder den entsprechenden ersten Steckverbindern eingerichtet. Dies führt dazu, daß die ersten Steckverbinder im Betriebszustand ohne Zwischenteile mit dem Einschubrahmen verbunden sind. Gegenüber dem Stand der Technik bedeutet dies, daß auf separate Zwischenstücke wie die L-förmigen Trays verzichtet werden kann. Ein separates Zwischenstück zwischen Einschubrahmen und erstem elektrischen Steckverbinder ist im Stand der Technik notwendig, damit ein einzelner erster Steckverbinder unabhängig vom Einschubrahmen ausgetauscht werden kann. Diese Austauschbarkeit ergibt sich im Rahmen der Erfindung aus der dem jeweiligen Einschubfach entsprechenden Höhe der Rückenteile.

Die Erfindung hat erkannt, daß die Zergliederung jeweils einer Reihe von Einschubfächern in Rahmenteile, deren Breite jeweils an die kleinste vorgesehene Einheit, nämlich ein Einschubfach, angepaßt ist, eine erhöhte Flexibilität bei gleichzeitig verringerter Teileanzahl gewährleistet. Insbesondere können Einschubrahmen mit jeweils einer gewünschten Anzahl von nebeneinander liegenden Einschubfächern pro Reihe und/oder mit jeweils beliebig breiten Reihen gebildet werden. Erfindungsgemäß ist die Erstellung eines Einschubrahmens mit einer beliebigen Zahl von Reihen mit jeweils einer beliebigen Anzahl von nebeneinanderliegenden Einschubfächern pro Reihe möglich. Im Ergebnis führt dies zu einem modularen Aufbau des Einschubrahmens, dessen Breite und Höhe individuell an die jeweiligen Gegebenheiten anpaßbar ist. Zum Auswechseln eines ersten Steckverbinders genügt es, einfach das dem Einschubfach entsprechende Rückenteil unabhängig von den übrigen ersten Steckverbindern zu entfernen. Aufgrund der Erfindung wird der Aufwand für Herstellung und Lagerhaltung der entsprechenden Rahmenteile verringert. Im Vergleich dazu müssen im Stand der Technik eine Vielzahl von Teilen vorgesehen sein, die einerseits sowohl an den jeweiligen Flugzeugtyp und für jeden Flugzeugtyp an den jeweiligen Einbauort angepaßt sind. Die für einen Flugzeugtyp und für einen spezifischen Einbauort vorgesehenen Teile können in der Regel nicht für einen anderen Einbauort oder gar einen anderen Flugzeugtyp verwendet werden.

Die Reduzierung der Anzahl unterschiedlicher Teile, die zur Bildung eines erfindungsgemäßen Einschubrahmens vorzuhalten sind, folgt daraus, daß für Rahmenteile einer bestimmten Höhe und Tiefe im wesentlichen lediglich eine der Zahl der gewünschten Breiten der Einschubfächer entsprechende,Sortenzahl von Boden-, Decken- und Rückenteilen sowie häufig nur eine einzige Sorte von Seitenteilen vorgesehen sein muß.

Dem liegt die Erkenntnis zugrunde, daß die Breiten der Elektronikeinheiten im internationalen Luftverkehr standardisiert sind. Die Standardbreiten folgen einem System mit einem Modul A, als ATR bezeichnet, das in ein feineres Raster, welches einem Grundmodul a folgt (gewöhnlich als MCU bezeichnet), unterteilt ist, wobei A ein ganzzahliges Vielfaches von a ist. Diese Einheiten liegen jeweils nicht exakt fest, sondern nur innerhalb gewisser Schwankungsbreiten. Zudem ist die ATR/MCU-Skala nicht linear. Die Höhe der Elektronikeinheiten liegt im allgemeinen fest, wobei jedoch sowohl Einschübe mit Über- als auch solche mit Unterhöhe gegenüber der Standardhöhe vorkommen. Den jeweiligen Höhen liegt ebenfalls wie bei den Breiten ein Schema zugrunde, das auf einem Modul und einem Grundmodul basiert. Die Tiefe der Einschübe liegt im allgemeinen fest, wobei jedoch ebenfalls abweichende Maße vorkommen. Die Erfindung ist nicht auf Elektronikeinheiten mit einer einzigen Höhe und/oder Breite festgelegt. Zusätzlich können Rahmenteile einer größeren Breite vorgesehen sein, um die rationale Erstellung von Einschubrahmen größerer Breiten zu ermöglichen. Unter einem ganzzahligen Vielfachen wird eine beliebige natürliche Zahl einschließlich der Zahl Eins verstanden.

Die Rahmenteile weisen daher solche Abmessungen auf, daß die Breite und/oder Höhe der Einschubfächer ganzzahlige Vielfache eines Moduls A ist, und zusätzliche Rahmenteile vorgesehen sind, deren Abmessungen sich um ganzzahliges Vielfaches eines Grundmoduls a unterscheiden, wobei das Modul A ein ganzzahliges Vielfaches des Grundmoduls a ist. Bei einem bewährten System ist A gleich 8 x a. A steht hierbei für eine Entfernung von etwa 256 mm entsprechend ca. 10,1 Zoll.

Die Rahmenteile sind zur lösbaren Verbindung miteinander eingerichtet. Es handelt sich also um solche Verbindungen, die ohne Beeinträchtigung der Rahmenteile wieder lösbar sind, ohne daß anschließend bspw. eines Säuberung der Rahmenteile erforderlich wäre. Dies kann bspw. mit Hilfe von Schraubverbindungen geschehen. Dagegen sind Klebverbindungen nicht von dieser vorteilhaften Ausführungsform umfaßt. Wenn die Verbindungen der Rahmenteile lösbar sind, kann ein Einschubrahmen demontiert und an anderer Stelle eingebaut werden. Allgemeiner gesagt kann jederzeit eine Anpassung an sich ändernde räumliche Bedingungen erfolgen.

Eine vorteilhafte Weiterbildung der Erfindung betrifft die Kühlung von in den Einschubrahmen eingeschobenen Elektronikeinheiten mit Hilfe eines Kühlmittel-, insbesondere Kühlluftstroms. Wenn nachfolgend von Kühlluft die Rede ist, sollen von diesem Begriff andere fluide, insbesondere gasförmige Kühlmittel mit umfaßt sein. Demnach sind vorteilhafterweise vollständig in die den Einschubrahmen bildenden Rahmenteile integrierte Kühlluftkammern vorgesehen, die jeweils eine oder mehrere in den Innenraum eines Einschubfachs gerichtete Kühlluftöffnungen aufweisen. Aufgrund der vollständigen Integration der Kühlluftkammern in die den Einschubrahmen bildenden Rahmenteile sind innerhalb des Einschubrahmens keine separaten Kühlluftleitungen erforderlich. Zweckmäßigerweise ist eine Kühlluftkammer zur Verbindung mit Kühlluftleitungen eingerichtet, die in Verbindung mit einer entsprechenden Kühlmittelquelle stehen.

Es ist besonders vorteilhaft, wenn die flächige Erstreckung einer Kühlluftkammer höchstens etwa den Abmessungen eines entsprechenden Einschubfachs entspricht. Diese Ausführungsform entspricht dem Grundgedanken der Modularität des Einschubrahmens. Es ist daher bspw. möglich, ein Einschubfach zu entfernen, ohne daß dadurch die Kühlung der übrigen Einschubfächer beeinträchtigt wird. Dies wäre der Fall, wenn sich eine Kühlluftkammer über zwei oder mehrere Einschubfächer erstreckt, so daß die Entfernung eines Einschubfachs die Versorgung benachbarter Einschubfächer unterbrechen könnte. Zweckmäßigerweise ist eine Kühlluftkammer demnach jeweils in ein einzelnes Rahmenteil integriert. Dabei handelt es sich vorzugsweise um ein Boden- und/oder Deckenteil.

Vorteilhafterweise sind einem Einschubfach neben mindestens einer Drucköffnung zur Kühlluftzufuhr auch mindestens eine Saugöffnung zur Abluftabsaugung zugeordnet, damit erwärmtes Kühlmittel nicht im Bereich des Einschubrahmens verbleibt, was der Kühlung insgesamt abträglich sein kann. Zweckmäßigerweise ist eine Abluftkammer zur Verbindung mit Abluftleitungen eingerichtet, die in Verbindung mit Einrichtungen zur Unterdruckerzeugung stehen. Die Abluftkammer bezeichnet eine mit einer Saugöffnung versehene Kühlluftkammer, die Zuluftkammer entsprechend eine mit einer Drucköffnung versehene Kühlluftkammer. Die Zuluft- und Abluftleitungen sind vorzugsweise in einem geschlossenen Kreislauf verbunden, welcher an die im Flugzeug vorhandenen Kühlsysteme angeschlossen werden kann. Eine beispielsweise verwendbare Form der Kühlung besteht darin, daß ein Teil des Kühlluftkreislaufs an der im Flugbetrieb kalten Außenhaut des Flugzeugs entlang geführt wird.

Vorteilhafterweise sind Druck- und Saugöffnung bezogen auf das jeweilige Einschubfach einander gegenüberliegend angeordnet, bspw. jeweils im entsprechenden Boden- und Deckenteil, um einen gleichförmig gerichteten Kühlmittelstrom zu bewirken.

Vorzugsweise ist für eine Kühlluftöffnung eine Regulierplatte (metering plate) zur Regulierung des Kühlluftdurchflusses vorgesehen. Zweckmäßigerweise ist eine Regulierplatte dichtend mit der entsprechenden Kühlluftkammer bzw. deren zum Innenraum des Einschubfaches weisenden Öffnung verbunden. Die Regulierplatte weist Reguliereinrichtungen auf. Dabei kann es sich einfach um Öffnungen eines bestimmten Durchmessers in der Regulierplatte handeln. Sämtliche Zuluftkammern können dann mit einem einheitlichen, ausreichend hohen Druck beaufschlagt sein; die jeweils für ein Einschubfach gewünschten Kühlluftdurchflüsse können individuell mit Hilfe der entsprechenden Regulierplatte eingestellt werden. Vorteilhafterweise sind dazu Verschließelemente, bspw. Gummistopfen vorgesehen, die zum Verschluß bzw. Öffnen einer den jeweiligen Bedürfnissen angepaßten Zahl von in der Regulierplatte vorgesehenen Regulieröffnungen (diese Regulieröffnungen sollen in der Regel mit entsprechenden Kühlmittelöffnungen im Gehäuse einer eingeschobenen LRU fluchten) dienen. Es müssen dann nicht jeweils Regulierplatten mit einer unterschiedlichen Anzahl von Regulieröffnungen vorgesehen sein, was zur Reduzierung der Teilezahl beiträgt.

Bevorzugt sind für zwei einander gegenüberliegende Zu- und Abluftöffnungen eines Einschubfachs einander entsprechende Regulierplatten versehen. Dies ist hilfreich für die Erzeugung eines gerichteten, gleichförmigen Kühlluftstroms.

Vorzugsweise wird als Werkstoff Kohlefaser verwendet. Kohlefaser hat den Vorteil, bei außerordentlicher Festigkeit ausgesprochen leicht zu sein. Beide Eigenschaften sind günstig im Hinblick auf die im Luftfahrtbereich gestellten Anforderungen. Die Festigkeit spielt bei dem erfindungsgemäßen Bauteilesatz eine besondere Rolle, da ein daraus hergestellter Einschubrahmen auch bei hohen Belastungen, z. B. in Turbulenz, die aufgenommenen Elektronikeinheiten sicher halten muß. Auch nur geringfügige Bewegungen der Elektronikeinheiten kann zu Kontaktschwierigkeiten und damit zu einem Ausfall des entsprechenden Systems führen. Berücksichtigt man noch, daß die Elektronikeinheiten zum Teil ein beträchtliches Gewicht aufweisen, so ist es um so wichtiger, daß die Bauteile eine entsprechend hohe Festigkeit aufweisen. Kohlefaser ist daher ein bevorzugter Werkstoff. Darüber hinaus hat Kohlefaser den Vorteil, daß es elektrisch nicht leitend ist und im übrigen auch amagnetisch. Letzeres kann insbesondere für Navigationsanlagen von Bedeutung sein, insbesondere für Fernkompaßanlagen.

Die Erfindung wird im folgenden anhand vorteilhafter Ausführungsbeispiele mit Bezug auf die beigefügten Figuren erläutert. Es zeigen:
- Fig. 1:: Perspektivische Ansicht eines ersten Einschubrahmens gemäß der Erfindung,
- Fig. 2:: Ansicht des Einschubrahmens aus Fig. 1 von vorne,
- Fig. 3:: Ansicht des Einschubrahmens aus Fig. 1 von rechts,
- Fig. 4:: Ansicht A-A des Einschubrahmens aus Fig. 2,
- Fig. 5:: Ansicht B-B des Einschubrahmens aus Fig. 2,
- Fig. 6:: Perspektivische Ansicht eines zweiten Einschubrahmens gemäß der Erfindung,
- Fig. 7:: Perspektivische Ansicht eines dritten Einschubrahmens gemäß der Erfindung,
- Fig. 8:: Perspektivische Ansicht eines vierten Einschubrahmens gemäß der Erfindung,
- Fig. 9:: Ansicht A-A des Einschubrahmens aus Fig. 8,
- Fig. 10:: Perspektivische Ansicht eines fünften Einschubrahmens gemäß der Erfindung.

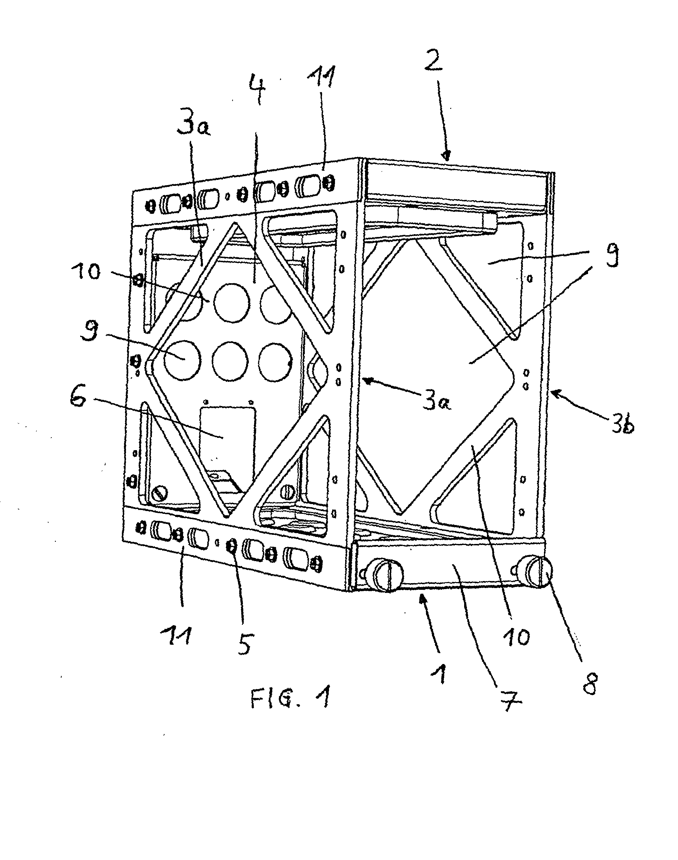

Der in Fig. 1 gezeigte Einschubrahmen besteht aus einem einzigen Einschubfach und wird von einem Bodenteil 1, einem Dekkenteil 2, zwei Seitenteilen 3a, 3b und einem Rückenteil 4 gebildet. Die Rahmenteile 1, 2, 3, 4 sind mit Hilfe von Schrauben 5 lösbar miteinander verbunden. Die miteinander verbundenen Rahmenteile 1, 2, 3, 4 bilden ein Einschubfach, in das von vorne eine Elektronikeinheit der Standardbreite 1/2 ATR (4 MCU) einschiebbar ist. Die Rückwand 4 weist an geeigneter Stelle eine Öffnung 6 auf, die zur Aufnahme eines elektrischen Adapters eingerichtet ist. Der eingesetzte Adapter wird fest mit der Rückwand 4 verbunden. Auf der Vorderseite der Rückwand 4, also der zum Einschubfach hin orientierten Seite, bildet der nicht in den Figuren gezeigte Adapter einen ersten elektrischen Steckverbinder. Eine in das Einschubfach einzuschiebende Elektronikeinheit weist an entsprechender Stelle einen zweiten elektrischen Steckverbinder auf. Beim Einschieben des Einschubs wird der zweiter Steckverbinder in den ersten Steckverbinder geführt, so daß beide Steckverbinder im eingeschobenen Zustand elektrisch in Kontakt sind. Auf der dem Einschubfach abgewandten Seite bildet der Adapter wiederum einen elektrischen Steckverbinder, der mit einem entsprechendem, mit elektrischen Versorgungs-und/oder Signalleitungen verbundenen Steckverbinder zusammenwirkt.

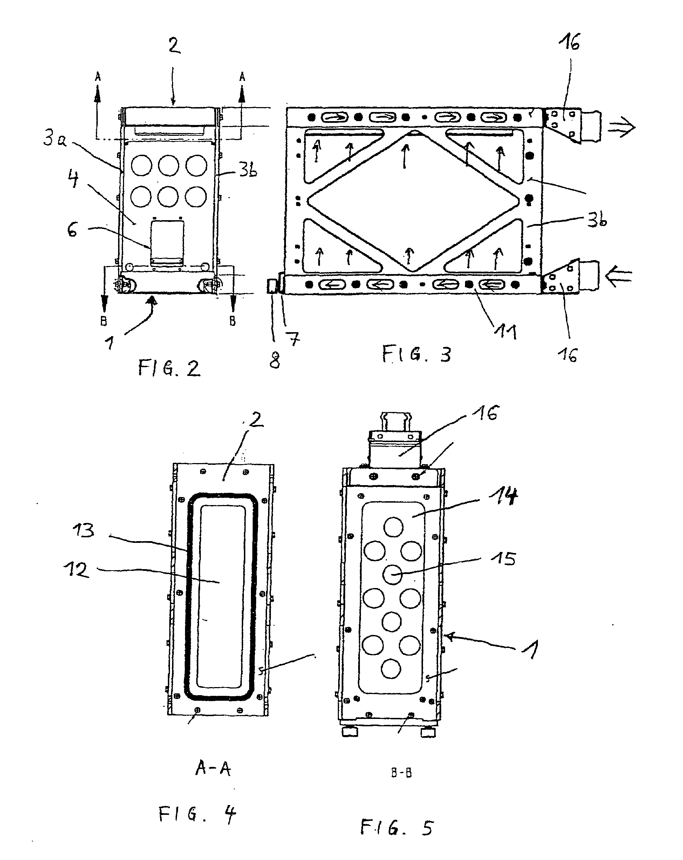

Ein eingeschobener Einschub wird mit Hilfe einer sich im wesentlichen über die Breite des Einschubfachs erstreckenden Lippe 7 festgesetzt, die in dem in Fig. 1 gezeigten arretierten Zustand nach oben über die Unterseite des Einschubfachs hinausragt, so daß eine Bewegung des Einschubs entgegen der Einschubrichtung durch Anschlag an der Lippe 7 verhindert wird. Die Lippe 7 wird mit Hilfe zweier Schrauben 8 festgesetzt. Zum Lösen der Arretierung werden die Schrauben 8 gelöst, woraufhin die Lippe 7 nach unten abgeklappt werden kann; in diesem geöffneten Zustand werden die Lippe 7 und die Schrauben 8 unverlierbar am Einschubrahmen gehalten. Die beschriebene Konstruktion, insbesondere die Verwendung einer flachen Haltelippe 7, ermöglicht eine gegenüber dem Stand der Technik verringerte Bautiefe (s. Fig. 3, 5). Da die Arretierungseinrichtung 7, 8 nicht mehr so weit hervorsteht, ergibt sich insgesamt ein verringerter Platzbedarf.

Die Rahmenteile, insbesondere die Seitenteile 3a, 3b und das Rückenteil 4, weisen Installationsöffnungen 9 auf. An den entsprechenden Stegen 10 können bspw. Kabel oder Führungseinrichtungen befestigt werden.

Die Leisten 11 dienen zum Ausfüllen entsprechender Nuten der Seitenteile 3a, 3b, deren Funktion später erläutert wird.

Sämtliche Bauteile sind gewichtsoptimiert. Bspw. bestehen die Rahmenteile 1, 2, 3, 4, 7, 11 vorzugsweise aus Aluminium bzw. einer Aluminiumlegierung. Ein weiterer bevorzugter Werkstoff sind Kohlefasern.

Die Kühlung wird im folgenden insbesondere unter Bezugnahme auf die Figuren 2 bis 5 erläutert. Das Deckenteil 2 schließt eine Hohlkammer ein, die sich etwa über die Ausdehnung der Deckenplatte 2 erstreckt. Sie weist eine nach unten, also zum Einschubfach hin gerichtete Kühlluftöffnung 12 mit einer Dichtung 13 auf. Zur Abdeckung der Öffnung 12 ist an der Unterseite des Deckenteils 2 eine Durchflußregulierplatte (metering plate) 14 aufgesetzt und verschraubt. Die Regulierplatte 14 enthält Regulierungsöffnungen 15, hier kreisförmige Bohrungen. Einzelne Bohrungen 15 sind mit hier nicht gezeigten Gummistopfen verschließbar, um eine gezielte Regulierung des Luftstroms zu ermöglichen.

Entsprechendes gilt sinngemäß für das Bodenteil 1. Auch dieses weist vorzugsweise eine dichtend aufgesetzte Durchflußregulierplatte 14 auf. Die Öffnung 12 ist in diesem Fall nach oben gerichtet.

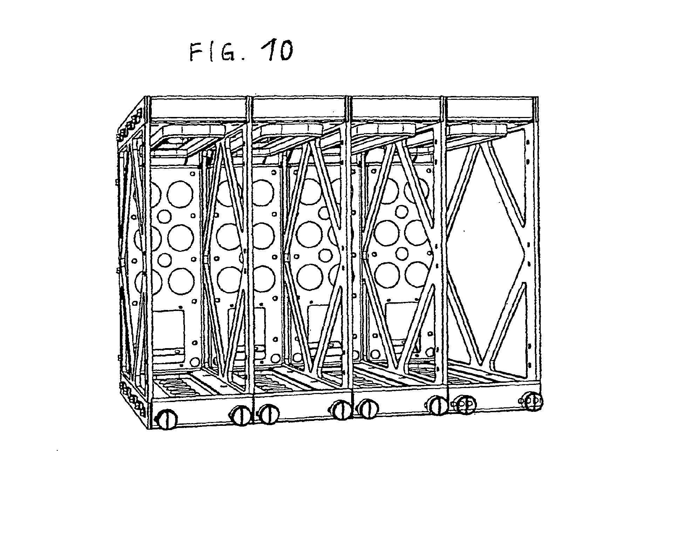

Bodenteil 1 und Deckenteil 2 weisen an ihrer Rückseite eine Öffnung auf, die jeweils mit einem Anschlußstück 16 vorzugsweise dichtend verbunden ist. An ihrem dem Einschubrahmen abgewandten Ende ist das Anschlußstück 16 zur Verbindung mit nicht gezeigten Leitungen, bspw. Schläuchen, zur Zufuhr bzw. Abfuhr von Kühlluft eingerichtet. Kühlluft wird über das dem Bodenteil 1 zugeordnete Anschlußstück 16 in die Kühlluftkammer des Bodenteils 1 eingeleitet und strömt durch die Öffnung 12 bzw. die Regulierungsöffnungen 15 in das Innere des Einschubfachs. Die Kühlluft durchströmt eine ggf. in das Einschubfach eingeschobene Elektronikeinheit. Das dem Deckenteil 2 zugeordnete Anschlußstück 16 wird an seinem dem Einschubfach abgewandten Ende mit Unterdruck beaufschlagt, so daß die aus einer ggf. eingeschobenen Elektronikeinheit austretende erwärmte Abluft durch die entsprechende Öffnung 12 bzw. die Regulierungsöffnungen 15 in die Kühlluftkammer des Deckenteils 2 und von dort durch das Anschlußstück 16 abgesaugt wird. Die dem Bodenteil 1 und dem Deckenteil 2 zugeordneten Anschlußstücke 16 sind vorzugsweise im Sinne eines Kühlluftkreislaufs verbunden, der an die jeweils in den Flugzeugen vorhandenen Kühlsysteme angeschlossen werden kann, um dort eine Kühlung der Kühlluft zu bewirken. Beispielsweise kann der Kühlkreislauf teilweise an der Außenhaut des Flugzeugs entlang geführt sein. Die Anschlußstücke 16 sind vorzugsweise universell an einem beliebigen Boden- und/oder Deckenteil verwendbar. In diesem Fall existiert nur eine einzige Sorte von Anschlußstücken 16, was die Teilevielfalt weiter reduziert. Die Anschlußstücke 16 sind insbesondere an einer Seite so abgeflacht gestaltet, daß sie in dem mit einem Boden- oder Deckenteil verbundenen Zustand mit dessen Außenseite fluchten oder jedenfalls nicht darüber hinaus vorstehen. Bei mehreren übereinanderliegenden Einschubfächern wird auf diese Weise eine Kollision der Anschlußstücke 16 miteinander vermieden (s. Fig. 9).

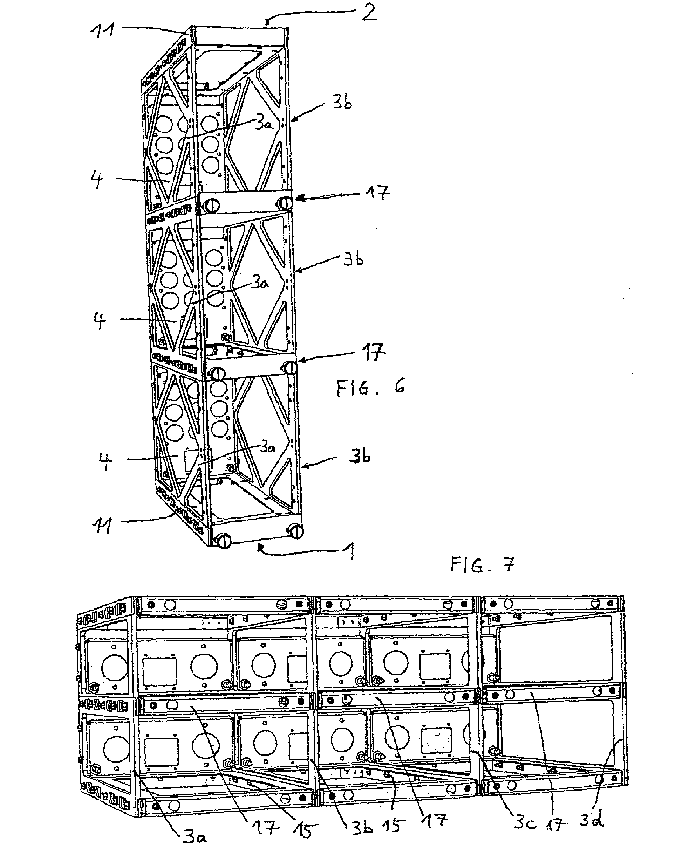

In Fig. 6 ist ein Einschubrahmen mit drei übereinander angeordneten Einschubfächern für Einschübe jeweils der Breite 1/2 ATR (4 MCU) gezeigt. Die Seitenteile 3a, 3b sind zur Verbindung miteinander in der Art von Nut-/Federverbindungen eingerichtet. Zu diesem Zweck besitzen sie an ihren oberen und unteren Enden sich über ihre gesamte Länge erstreckende Nuten. Die Nuten greifen wechselseitig ineinander, wobei bspw. bei dem mittleren Seitenteil 3a in Fig. 6 die Nuten nach innen, bei dem oberen und unteren Seitenteil 3a dagegen nach außen weisen. Aufgrund dieser Gestaltung genügt im vorliegenden Ausführungsbeispiel eine einzige Sorte von Seitenteilen 3a, 3b. Am oberen und unteren Ende des Einschubrahmens sind die Nuten der Seitenteile 3a, 3b mit Leisten 11 verschlossen. In der Ausführungsform gemäß Fig. 6 bildet bspw. das Deckenteil des unteren Einschubfachs gleichzeitig das Bodenteil des mittleren Einschubfachs. Dieses Zwischenteil 17 ist demnach sowohl dem unteren als auch dem mittleren Einschubfach zugeordnet und besitzt dementsprechend sowohl eine nach unten als auch eine nach oben gerichtete Kühlluftöffnung 12. Beide Kühlluftöffnungen 12 sind vorzugsweise mit Durchflußregulierplatten 14 versehen. Das Zwischenteil 17 ist an seiner Rückseite zur Verbindung mit lediglich einem Anschlußstück 16 eingerichtet. Das Kühlschema kann in Fig. 6 bspw. wie folgt aussehen. In das Bodenteil des unteren Einschubfachs wird ein Kühlluftstrom vom Betrag j eingeleitet. Aus dem darüberliegenden Zwischenboden 17 wird ein Abluftstrom vom Betrag 2j abgesaugt. In den darüberliegenden Zwischenboden wird ein Kühlluftstrom vom Betrag 2j eingeleitet. Aus dem Deckenteil 2 des oberen Einschubfachs wird ein Abluftstrom vom Betrag j abgesaugt. Auf diese Weise wird ein einheitlicher Luftstrom des Betrags j durch sämtliche Einschubfächer bewirkt. Mit Hilfe der bereits erwähnten Verschlußstopfen für die Regulieröffnungen 15 kann für jedes Einschubfach individuell der gewünschte Kühlluftstrom eingestellt werden.

Die Verwendung eines Zwischenbodens 17 anstelle eines separaten Bodenteils 1 und Deckenteils 2 führt zu einer insgesamt verringerten Bauhöhe.

Fig. 7 zeigt einen Einschubrahmen mit zwei Reihen von jeweils drei Einschubfächern für Videoeinheiten der Breite 3/4 ATR (6 MCU), die gegenüber der Höhe der Einschubfächer aus den Fig. 1, 6, 8 Unterhöhe aufweisen. Hinsichtlich der Nut-/ Federverbindung der Seitenteile sowie der Verwendung von Zwischenböden 17 gilt das zu Fig. 6 Gesagte entsprechend. Die mittleren Seitenteile 3b, 3c sind jeweils den rechts und links von ihnen liegenden Einschubfächern zugeordnet. Es ist daher nicht notwendig, für jedes Einschubfach zwei separate Seitenteile vorzusehen. Dies führt zu einem verringerten Aufwand und einer insgesamt reduzierten Breite. Die Rahmenteile 1, 2, 3, 4, 17 sind mit Hilfe von übergreifenden Schrauben oder Schraubbolzen 15 miteinander verbunden.

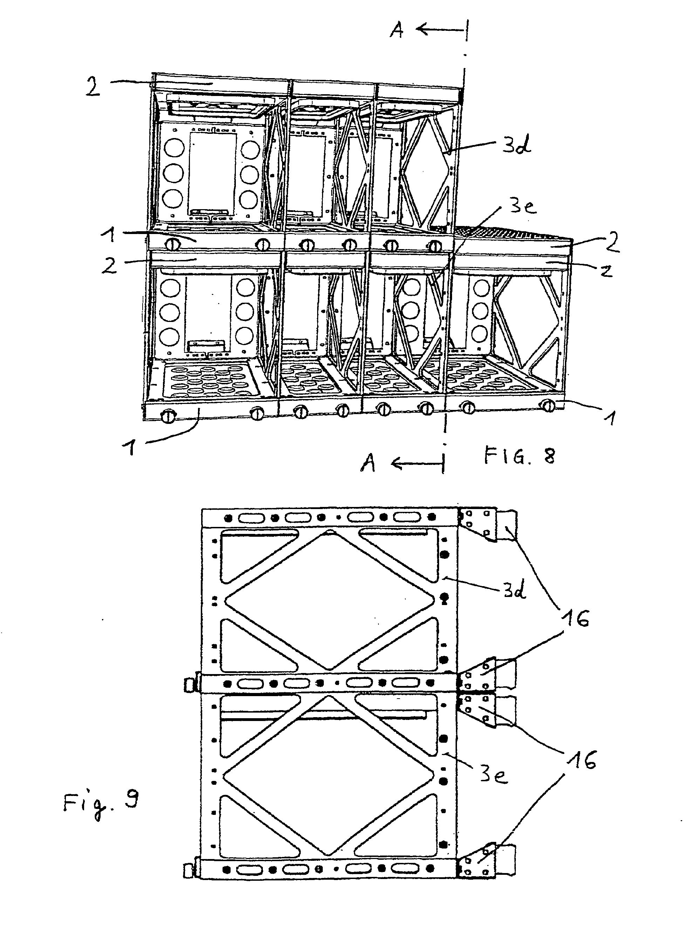

Fig. 8 zeigt einen Einschubrahmen mit einer unteren Reihe von vier Einschubfächern der Breiten sechs, vier, vier, sechs MCU und eine oben liegende Reihe von drei Einschubfächern der Breiten sechs, vier, vier MCU. Die Einschubfächer weisen dieselbe Höhe auf wie die der Fig. 1 und 6. Im Gegensatz zu den Ausführungsformen der Fig. 6, 7 sind hier für sämtliche Einschubfächer jeweils ein separater Bodenteil 1 und Deckenteil 2 vorgesehen. Die oberen Seitenteile 3d entsprechen den Seitenteilen der Ausführungsformen gemäß Fig. 1 und 6. Die unteren Seitenteile 3e weisen eine demgegenüber um die Höhe eines Bodenteils 1 vergrößerte Höhe auf. Sie erstrecken sich insoweit auch über den Bodenteil 1 eines der oberen Einschubfächer. Dennoch erfüllen sie die Eigenschaft, sich im wesentlichen nur über ein einzelnes (unteres) Einschubfach zu erstrecken. Zum Ausgleich der Überhöhe ist über dem Einschubfach rechts unten ein weiteres Deckenteil 2 vorgesehen.

Aus Fig. 9 ist ersichtlich, daß die einseitige Abflachung der Anschlußstücke 16 eine Kollision insbesondere der mittleren beiden Anschlußstücke vermieden wird.

Fig. 10 zeigt einen Einschubrahmen mit einer Reihe von vier nebeneinanderliegenden Einschubfächern für Elektronikeinheiten der Breite 3/8 ATR (3 MCU) auf, die gegenüber den Einschubfächern der Einschubrahmen gemäß Fig. 1, 6 und 8 Überhöhe aufweisen.

Die gezeigten Ausführungsbeispiele betreffen solche Einschubrahmen, bei denen die Seitenteile jeweils eine von oben bis unten durchgehende Wand bilden. Dies soll keine Einschränkung darstellen. Im allgemeinen können die Seitenteile von Reihe zu Reihe beliebig zueinander versetzt angeordnet sein. Dagegen bilden die Decken- bzw. Bodenteile in der Regel durchgehende Reihen (shelf-Struktur); die Erfindung ist jedoch darauf ebenfalls nicht beschränkt.

## Patentansprüche

1. Modularer Luftfahrzeugeinschubrahmen .
a) umfassend im wesentlichen flache Rahmenteile, nämlich Bodenteile (1), Deckenteile (2), Seitenteile (3) und Rückenteile (4), und erste elektrische Steckverbinder,
b) wobei die Rahmenteile (1, 2, 3, 4) so eingerichtet sind, daß sie sich zu einem Einschubfach zum unabhängigen Einschieben bzw. Ausziehen einer Elektronikeinheit, die mit einem zweiten elektrischen Steckverbinder versehen ist, verbinden lassen, so daß
c) der einheitliche Einschubrahmen gebildet ist durch mehrere übereinander oder nebeneinander liegende Einschubfächer,
wobei den Einschubfächern jeweils einer der ersten elektrischen Steckverbinder so zugeordnet ist, daß ein Zusammenwirken des ersten Steckverbinders mit dem entsprechenden zweiten Steckverbinder einer Elektronikeinheit allein infolge des Einschiebens der Elektronikeinheit in das Einschubfach bewirkbar ist,
**dadurch gekennzeichnet, daß**
die Rahmenteile (1, 2, 3, 4) beliebig aneinanderreihbar ausgeführt sind, so daß der einheitliche Einschubrahmen , eine beliebige Anzahl von übereinander und nebeneinander angeordneten Einschubfächern aufweist, wobei die Rahmenteile (1, 2, 3, 4) zur lösbaren Verbindung miteinander eingerichtet sind,
die Rahmenteile (1, 2, 3, 4) solche Abmessungen aufweisen, daß die Breite und/oder Höhe der Einschubfächer ganzzahlige Vielfache eines Moduls A ist, und zusätzliche Rahmenteile vorgesehen sind, deren Abmessung sich um ein ganzzahliges Vielfaches eines Grundmoduls a unterscheiden, wobei das Modul A ein ganzzahliges Vielfaches des Grundmoduls a ist, und
die Rückenteile (4) jeweils zur Verbindung mit dem oder den entsprechenden ersten Steckverbindern eingerichtet sind.

2. Modularer Luftfahrzeugeinschubrahmen nach Anspruch' 1, **dadurch gekennzeichnet, daß** die Breite mindestens eines Teils der Bodenteile (1), Deckenteile (2) und/oder Rükkenteile (4) jeweils der Breite eines Einschubfachs und die Höhe mindestens eines Teils der Rückenteile (4) jeweils der Höhe eines Einschubfachs entspricht.

3. Modularer Luftfahrzeugeinschubrahmen nach einem der Ansprüche 1 bis 2, **dadurch gekennzeichnet, daß** die Einschubfächer jeweils eine Breite aufweisen, die einer der folgenden Standardbreiten entspricht:
| **Breite** | | **Breite [mm]** | | **Breite [inches]** | |
|---|---|---|---|---|---|
| **[ATR]** | **[MCU]** | **Minimum** | **Maximum** | **Minimum** | **Maximum** |
| 1/8 | 1 | 25.15 | 25.65 | 0.990 | 1.010 |
| 1/4 | 2 | 56.64 | 57.66 | 2.230 | 2.270 |
| 3/8 | 3 | 89.92 | 90.94 | 3.540 | 3.580 |
| 1/2 | 4 | 123.44 | 124.46 | 4.860 | 4.900 |
| 5/8 | 5 | 156.72 | 157.74 | 6.170 | 6.210 |
| 3/4 | 6 | 190.00 | 191.02 | 7.480 | 7.520 |
| 7/8 | 7 | 222.76 | 223.78 | 8.770 | 8.810 |
| 1 | 8 | 255.78 | 256.80 | 10.070 | 10.110 |
| 1 1/8 | 9 | 288.80 | 289.82 | 11.370 | 11.410 |
| 1 1/4 | 10 | 321.82 | 322.84 | 12.670 | 12.710 |
| 1 3/8 | 11 | 354.84 | 355.86 | 13.970 | 14.010 |
| 1 1/2 | 12 | 387.86 | 388.88 | 15.270 | 15.310 |
usw.

4. Modularer Luftfahrzeugeinschubrahmen nach einem der Ansprüche 1 bis 3, **dadurch gekennzeichnet, daß** die Seitenteile (3) zur Nut-/ Feder-Verbindung miteinander eingerichtet sind.

5. Modularer Luftfahrzeugeinschubrahmen nach einem der Ansprüche 1 bis 4, **dadurch gekennzeichnet, daß** vollständig in die den Einschubrahmen bildenden Rahmenteile (1, 2, 3, 4) integrierte Kühlluftkammern mit jeweils einer oder mehreren in den Innenraum eines Einschubfachs gerichteten Kühlluftöffnungen (12) vorgesehen sind.

6. Modularer Luftfahrzeugeinschubrahmen nach Anspruch 5, **dadurch gekennzeichnet, daß** die flächige Erstreckung einer Kühlluftkammer (12) etwa den Abmessungen des entsprechenden Einschubfachs entspricht.

7. Modularer Luftfahrzeugeinschubrahmen nach Anspruch 5 , oder 6, **dadurch gekennzeichnet, daß** einem Einschubfach jeweils mindestens eine Kühlluft-Drucköffnung (12) und mindestens eine Kühlluft-Saugöffnung (12) zugeordnet ist.

8. Modularer Luftfahrzeugeinschubrahmen nach einem der Ansprüche 5 bis 7, **dadurch gekennzeichnet, daß** mindestens eine der einem Einschubfach zugeordneten Kühlluftöffnungen (12) mit einer Regulierplatte (14) versehen ist.

9. Modularer Luftfahrzeugeinschubrahmen nach Anspruch 8, **dadurch gekennzeichnet, daß** die Regulierplatte (14) dichtend mit der Kühlluftöffnung (12) verbunden ist.

10. Modularer Luftfahrzeugeinschubrahmen nach Anspruch 8 oder 9, **dadurch gekennzeichnet, daß** Verschließelemente vorgesehen sind, mit denen eine gewünschte Anzahl von in der Regulierplatte (14) vorgesehenen Regulieröffnungen (15) verschließbar ist.

11. Modularer Luftfahrzeugeinschubrahmen nach einem der Ansprüche 1 bis 10, **dadurch gekennzeichnet, daß** die ersten Steckverbinder Teile von Adaptern sind.

12. Modularer Luftfahrzeugeinschubrahmen nach einem der Ansprüche 1 bis 11, **dadurch gekennzeichnet, daß** als Werkstoff Kohlefaser verwendet wird.

## Claims

1. Modular aircraft mounting rack
a) essentially comprising flat rack parts, that is to say base parts (1), cover parts (2), side parts (3) and rear parts (4), and first electrical plug connectors,
b) the rack parts (1, 2, 3, 4) being designed such that they can be connected to form a drawer for independent insertion and withdrawal of an electronics unit which is provided with a second electrical plug connector, such that
c) the standard mounting rack is formed by two or more drawers which are located one above the other or alongside one another,
with the drawers each being associated with one of the first electrical plug connectors, such that the first plug connector can interact with the corresponding second plug connector of an electronics unit solely as a result of the insertion of the electronics unit into the drawer,
**characterized in that**
the rack parts (1, 2, 3, 4) are designed such that they can be arranged in rows as required, such that the standard mounting rack has any desired number of drawers which are arranged one above the other and alongside one another, with the rack parts (1, 2, 3, 4) being designed to be detachably connected to one another,
the rack parts (1, 2, 3, 4) have dimensions such that the width and/or the height of the drawers are/is an integer multiple of a module A, and additional rack parts are provided, whose dimensions differ by an integer multiple of a basic module a, with the module A being an integer module of the basic module a, and
the rear parts (4) are each designed for connection to the corresponding first plug connector or connectors.

2. Modular aircraft mounting rack according to Claim 1, **characterized in that** the width of at least some of the base parts (1), of the cover parts (2) and/or of the rear parts (4) in each case corresponds to the width of a drawer, and the height of at least some of the rear parts (4) in each case corresponds to the height of a drawer.

3. Modular aircraft mounting rack according to one of Claims 1 to 2, **characterized in that** the drawers each have a width which corresponds to one of the following standard widths:
| Width | | Width [mm] | | Width [inches] | |
|---|---|---|---|---|---|
| [ATR] | [MCU] | Minimum | Maximum | Minimum | Maximum |
| 1/8 | 1 | 25.15 | 25.65 | 0.990 | 1.010 |
| 1/4 | 2 | 56.64 | 57.66 | 2.230 | 2.270 |
| 3/8 | 3 | 89.92 | 90.94 | 3.540 | 3.580 |
| 1/2 | 4 | 123.44 | 124.46 | 4.860 | 4.900 |
| 5/8 | 5 | 156.72 | 157.74 | 6.170 | 6.210 |
| 3/4 | 6 | 190.00 | 191.02 | 7.480 | 7.520 |
| 7/8 | 7 | 222.76 | 223.78 | 8.770 | 8.810 |
| 1 | 8 | 255.78 | 256.80 | 10.070 | 10.110 |
| 1 1/8 | 9 | 288.80 | 289.82 | 11.370 | 11.410 |
| 1 1/4 | 10 | 321.82 | 322.84 | 12.670 | 12.710 |
| 1 3/8 | 11 | 354.84 | 355.86 | 13.970 | 14.010 |
| 1 1/2 | 12 | 387.86 | 388.88 | 15.270 | 15.310 |
etc.

4. Modular aircraft mounting rack according to one of Claims 1 to 3, **characterized in that** the side parts (3) are designed to be connected to one another by means of a tongue and groove connection.

5. Modular aircraft mounting rack according to one of Claims 1 to 4, **characterized in that** cooling air chambers which are completely integrated in the rack parts (1, 2, 3, 4) which form the mounting rack are each provided with one or more cooling air openings (12) which point into the interior of a drawer.

6. Modular aircraft mounting rack according to Claim 5,
**characterized in that** the flat extent of a cooling air chamber (12) corresponds approximately to the dimensions of the corresponding drawer.

7. Modular aircraft mounting rack according to Claim 5 or 6, **characterized in that** each drawer has at least one associated cooling air pressure opening (12) and at least one cooling air suction opening (12).

8. Modular aircraft mounting rack according to one of Claims 5 to 7, **characterized in that** at least one of the cooling air openings (12) which is associated with a drawer is provided with a metering plate (14).

9. Modular aircraft mounting rack according to Claim 8, **characterized in that** the metering plate (14) is connected to the cooling air opening (12) such that it is sealed.

10. Modular aircraft mounting rack according to Claim 8 or 9, **characterized in that** closure elements are provided, by means of which a desired number of metering openings (15), which are provided in the metering plate (14), can be closed.

11. Modular aircraft mounting rack according to one of Claims 1 to 10, **characterized in that** the first plug connectors are parts of adaptors.

12. Modular aircraft mounting rack according to one of Claims 1 to 11, **characterized in that** carbon fibre is used as the material.

## Revendications

1. Châssis modulaire d'insertion pour aéronef
a) comportant essentiellement des pièces de châssis planes, en l'occurrence des pièces de fond (1), des pièces de plafond (2), des pièces latérales (3) et des pièces arrière (4), et des premiers connecteurs électriques,
b) dans lequel les pièces du châssis (1, 2, 3, 4) sont agencées de telle sorte qu'elles peuvent être assemblées pour donner un compartiment d'insertion pour y inserrer ou en extraire indépendamment une unité électronique qui est dotée d'un deuxième connecteur électrique, de telle sorte que
c) le châssis modulaire d'insertion est formé de plusieurs compartiments d'insertion se trouvant les uns au-dessus des autres ou les uns à côté des autres,
l'un des premiers connecteurs électriques étant affecté à chacun des compartiments d'insertion de telle sorte qu'une coopération du premier connecteur avec le deuxième connecteur correspondant d'une unité électronique peut être obtenue par le seul enfichage de l'unité électronique dans le compartiment d'insertion,
**caractérisé en ce que**
les pièces du châssis (1, 2, 3, 4) sont réalisées de façon à pouvoir être alignées à volonté les unes contre les autres, de telle sorte que le châssis d'insertion unitaire comporte un nombre quelconque de compartiments d'insertion disposés les uns à côté des autres et les uns au-dessus des autres, les pièces du châssis (1, 2, 3, 4) étant disposées pour un assemblage démontable les unes avec les autres,
les pièces du châssis (1, 2, 3, 4) présentent des dimensions telles que la largeur et/ou la hauteur des compartiments d'insertion est un multiple entier d'un module A, et **en ce que** des pièces de châssis supplémentaires sont prévues, dont les dimensions diffèrent d'un multiple entier d'un module de base a, le module A étant un multiple entier du module de base a, et
les pièces arrière (4) sont disposées chacune pour la connexion avec le ou les premiers connecteurs à enfichage correspondants.

2. Châssis modulaire d'insertion pour aéronef selon la revendication 1, **caractérisé en ce que** la largeur d'au moins une partie des pièces de fond (1), des pièces de plafond (2) et/ou des pièces arrière (4) correspond chaque fois à la largeur d'un compartiment d'insertion et **en ce que** la hauteur d'au moins une partie des pièces arrière (4) correspond chaque fois à la hauteur d'un compartiment d'insertion.

3. Châssis modulaire d'insertion pour aéronef selon l'une des revendications 1 à 2, **caractérisé en ce que** les compartiments d'insertion présentent respectivement une largeur qui correspond à une des largeurs standard suivantes :
| Largeur | | Largeur [mm] | | Largeur [pouces] | |
|---|---|---|---|---|---|
| [ATR] | [MCU] | Minimum | Maximum | Minimum | Maximum |
| 1/8 | 1 | 25.15 | 25.65 | 0.990 | 1.010 |
| 1/4 | 2 | 56.64 | 57.66 | 2.230 | 2.270 |
| 3/8 | 3 | 89.92 | 90.94 | 3.540 | 3.580 |
| 1/2 | 4 | 123.44 | 124.46 | 4.860 | 4.900 |
| 5/8 | 5 | 156.72 | 157.74 | 6.170 | 6.210 |
| 3/4 | 6 | 190.00 | 191.02 | 7.480 | 7.520 |
| 7/8 | 7 | 222.76 | 223.78 | 8.770 | 8.810 |
| 1 | 8 | 255.78 | 256.80 | 10.070 | 10.110 |
| 1 1/8 | 9 | 288.80 | 289.82 | 11.370 | 11.410 |
| 1 1/4 | 10 | 321.82 | 322.84 | 12.670 | 12.710 |
| 13/8 | 11 | 354.84 | 355.76 | 13.970 | 14.010 |
| 1 1/2 | 12 | 387.86 | 388.88 | 15.270 | 15.310 |
etc.

4. Châssis modulaire d'insertion pour aéronef selon l'une des revendications 1 à 3, **caractérisé en ce que** les pièces latérales (3) sont disposées ensemble pour un assemblage à rainure et languette.

5. Châssis modulaire d'insertion pour aéronef selon l'une des revendications 1 à 4, **caractérisé en ce que** des chambres à air de refroidissement complètement intégrées dans les pièces (1, 2, 3, 4) formant le châssis d'insertion sont prévues, avec respectivement un ou plusieurs orifices d'air de refroidissement (12) dirigés dans l'espace intérieur d'un compartiment d'insertion.

6. Châssis modulaire d'insertion pour aéronef selon la revendication 5, **caractérisé en ce que** l'extension bidimensionnelle d'une chambre à air de refroidissement (12) correspond à peu près aux dimensions du compartiment d'insertion correspondant.

7. Châssis modulaire d'insertion pour aéronef selon la revendication 5 ou 6, **caractérisé en ce qu'**à un compartiment d'insertion sont affectés respectivement au moins un orifice de refoulement de l'air de refroidissement (12) et au moins un orifice d'aspiration de l'air de refroidissement (12).

8. Châssis modulaire d'insertion pour aéronef selon l'une des revendications 5 à 7, **caractérisé en ce qu'**au moins un des orifices d'air de refroidissement (12) affectés à un compartiment d'insertion est doté d'une plaque de réglage (14).

9. Châssis modulaire d'insertion pour aéronef selon la revendication 8, **caractérisé en ce que** la plaque de réglage (14) est reliée avec étanchéité à l'orifice d'air de refroidissement (12).

10. Châssis modulaire d'insertion pour aéronef selon la revendication 8 ou 9, **caractérisé en ce que** des éléments de fermeture sont prévus, avec lesquels un nombre désiré des ouvertures de réglage (15) prévues dans la plaque de réglage (14) peuvent être fermées.

11. Châssis modulaire d'insertion pour aéronef selon l'une des revendications 1 à 10, **caractérisé en ce que** les premiers connecteurs à enfichage sont des pièces d'adaptateurs.

12. Châssis modulaire d'insertion pour aéronef selon l'une des revendications 1 à 11, **caractérisé en ce que** de la fibre de carbone est utilisée comme matériau.
